# EUROPÄISCHE PATENTANMELDUNG

(11) **EP 1 328 009 A2**
(43) Veröffentlichungstag der Anmeldung: **16.07.2003**
(21) Anmeldenummer: 02026760.5
(22) Anmeldetag: 02.12.2002
(51) Int. Cl.: H01L 21/00

(54) **Vorrichtung zum Aufbringen eines Mediums auf einem Substrat**

(30) Priorität: 15.01.2002 DE 10201120
(71) Anmelder: ROBERT BOSCH GMBH, 70442 Stuttgart (DE)
(72) Erfinder: Kugler, Andreas, 73553 Altdorf (DE); Hoehn, Michael, 87538 Obermaiselstein (DE); Gebert, Tobias, 70174 Stuttgart (DE); Woehr, Matthias, 71277 Rutesheim (DE)

(57) **Zusammenfassung**

Es wird eine Vorrichtung zum Aufbringen eines Mediums an einer Aufbringposition auf einem Substrat (4), insbesondere zum Pin-Transfer von Klebstoff, mit einer ersten Verfahreinheit zum Verfahren wenigstens eines Stempels (2) zur Aufbringposition, wobei der Stempel (2) zur Aufnahme des Mediums an einer Aufnahmeposition wenigstens teilweise in das in einem ersten Mediumspeicher (10) bevorratete Medium eintaucht, vorgeschlagen, mit der wesentlich kürzere Taktzeiten realisiert werden. Dies wird erfindungsgemäß dadurch erreicht, dass wenigstens eine zweite Verfahreinheit (6, 8, 13) zum Verfahren des Stempels zur Aufnahmeposition vorgesehen ist, wobei die zweite Verfahreinheit (6, 8, 13) mittels der ersten Verfahreinheit verfahrbar ist.

## Beschreibung

Die Erfindung betrifft eine Vorrichtung zum Aufbringen eines Mediums an einer Aufbringposition auf einem Substrat, insbesondere zum Pin-Transfer von Klebstoff, mit einer ersten Verfahreinheit zum Verfahren wenigstens eines Stempels zur Aufbringposition nach dem Oberbegriff des Anspruchs 1.

### Stand der Technik

Bislang werden bei der Chipmontage Halbleiterchips häufig mit elektrisch leitfähigen Klebstoffen auf dem Trägersubstrat fixiert. In heute bekannten Chipmontagenautomaten, sogenannten Die-Bondern, wird der Klebstoff unter anderem in Stempeltechnik auf das Substrat appliziert. Diese Methode wird auch als Pin-Transfer bezeichnet.

Bei der Stempeltechnik wird im Allgemeinen der Kleber in einem Vorratsbehälter mit einer Abstreiferkante, einem sogenannten Rakel, in definierter, konstanter Dicke in einer Kavität ausgestrichen. Ein Metallstempel wird in die dünne Klebstoffschicht eingetaucht. Durch Adhäsionskräfte bleibt eine bestimmte Menge Klebstoff am Stempel haften. Anschließend wird der Stempel auf die Klebestelle gedrückt und hinterlässt dort einen Teil des an ihm haftenden Klebers (vgl. z.B. US 6,293,317; JP 825 74 84; JP 61 77 204). Der Stempel muss nach jedem Klebstoffauftrag wieder erneut Klebstoff aus dem Vorratsbehälter aufnehmen. Klebermenge und Auftragsstärke können durch die Variation der Schichtdicke des Klebers in der Kavität bzw. durch die Tiefe der Kavität, der Stempelform und des Stempeldruckes kontrolliert werden und sind für den Fügeprozess von besonderer Bedeutung. Nach erfolgtem Kleberauftrag kann das Substrat mit Bauteilen, insbesondere Chips, bestückt werden.

Gemäß dem Stand der Technik ist der Stempel im Allgemeinen an einem Handhabungssystem bzw. einer Verfahreinheit angeordnet, mit dem bzw. der Stempel in die drei Raumrichtungen X, Y und Z verfahren werden kann. Mit Hilfe des Handhabungssystems verfährt der Stempel insbesondere zur Aufbringposition auf dem Substrat und zur Aufnahmeposition über der Kavität.

Nachteilig bei Vorrichtungen gemäß dem Stand der Technik sind die vergleichsweise langen, unproduktiven Verfahrzeiten von der Aufnahme bis zum Aufbringen des Klebstoffs, wodurch sich lediglich relativ lange Taktzeiten des Bestückungsprozesses, insbesondere beim Applizieren mehrerer Klebepunkte auf einem Substrat, realisieren lassen.

### Aufgabe und Vorteile der Erfindung

Aufgabe der Erfindung ist es demgegenüber, eine Vorrichtung zum Aufbringen eines Mediums an einer Aufbringposition auf einem Substrat, insbesondere zum Pin-Transfer von Klebstoff, mit einer ersten Verfahreinheit zum Verfahren wenigstens eines Stempels zur Aufbringposition, wobei der Stempel zur Aufnahme des Mediums an eine Aufnahmeposition wenigstens teilweise in das in einem ersten Mediumspeicher bevorratete Medium eintaucht, vorzuschlagen, mit der wesentlich kürzere Taktzeiten realisiert werden.

Diese Aufgabe wird, ausgehend von einer Vorrichtung der einleitend genannten Art, durch die kennzeichnenden Merkmale des Anspruchs 1 gelöst.

Durch die in den Unteransprüchen genannten Maßnahmen sind vorteilhafte Ausführungen und Weiterbildungen der Erfindung möglich.

Dementsprechend zeichnet sich eine erfindungsgemäße Vorrichtung dadurch aus, dass wenigstens eine zweite Verfahreinheit zum Verfahren des Stempels zur Aufnahmeposition vorgesehen ist, wobei die zweite Verfahreinheit mittels der ersten Verfahreinheit verfahrbar ist.

Gemäß der Erfindung ist durch die Verwendung von einer zweiten, zusätzlichen Verfahreinheit, die in vorteilhafter Weise einen um ein Vielfaches kleineren Verfahrweg wie die erste Verfahreinheit aufweist, die Realisierung der Relativbewegung des Stempels zum Vorratsbehälter in relativ kurzer Zeit realisierbar. Demgegenüber wird gemäß dem Stand der Technik die Relativbewegung des Stempels zum Vorratsbehälter einer separaten Rakelstation mittels der ersten, vergleichsweise großdimensionierten und trägen Verfahreinheit mit einem vergleichsweise großen Verfahrweg verwirklicht.

Beim Stand der Technik wird zudem die erste Verfahreinheit sowohl zum Verfahren zu/weg von der Aufnahmeposition als auch zum Verfahren zu/weg von der Aufbringposition auf dem Substrat verwendet. Mit Hilfe der zweiten, relativ klein zu dimensionierenden Verfahreinheit gemäß der Erfindung kann gegebenenfalls das Verfahren des Stempels zu/weg von der Aufnahmeposition sowie zu/weg von der Aufbringposition wenigstens teilweise zeitgleich erfolgen.

Aufgrund der zuvor genannten Maßnahmen können die unproduktiven Nebenzeiten zum Verfahren des Stempels zwischen der Aufnahmeposition und der Aufbringposition deutlich reduziert bzw. teilweise simultan ausgeführt werden. Dies führt zu wesentlich kürzeren Taktzeiten bei einer erfindungsgemäßen Vorrichtung, so dass deren Produktivität entscheidend erhöht werden kann.

In einer besonderen Weiterbildung der Erfindung sind wenigstens die zweite Verfahreinheit, der Stempel und der erste Mediumspeicher als eine integrierte Baueinheit ausgebildet. Hiermit kann eine besonders kompakte Baueinheit beispielsweise als an der ersten Verfahreinheit angeordneter Stempelkopf realisiert werden. Diese Maßnahme ermöglicht besonders kurze Verfahrwege und somit besonders kurze Verfahrzeiten des Stempels. Die Baueinheit kann möglicherweise mit relativ kleinen zu bewegenden Massen realisiert werden. Demzufolge kann insbesondere die Antriebseinheit der zweiten Verfahreinheit zur Verwirklichung relativ großer Verfahrgeschwindigkeit entsprechend klein dimensioniert werden, was zur Reduzierung der Herstellungs- bzw. Betriebskosten führt.

Vorzugsweise umfasst die zweite Verfahreinheit wenigstens eine drehbar gelagerte Rotationseinheit zum radialen Verfahren des Stempels. Beispielsweise ist die Rotationseinheit als Karussell bzw. Revolverkopf ausgebildet. Vorteilhafterweise ist eine Drehachse der Rotationseinheit quer, insbesondere nahezu senkrecht, zur Substratebene angeordnet.

In einer bevorzugten Variante der Erfindung sind wenigstens zwei Stempel vorgesehen. Hiermit wird ermöglicht, dass in vorteilhafter Weise gegebenenfalls zwei oder mehrere Arbeitsschritte im Wesentlichen zeitgleich bzw. parallelisiert durchgeführt werden können, wodurch sich die Taktzeit des Bestückungsprozesses der Vorrichtung gemäß der Erfindung zusätzlich verringert.

Beispielsweise umfasst die zweite Verfahreinheit mindestens zwei Stempel. Vorzugsweise ist die Rotationseinheit als Karussell bzw. Revolvervorrichtung mit mehreren Stempeln auszuführen. Im Allgemeinen kann mit zunehmender Anzahl an Stempeln eine Reduzierung der Taktzeit des Bestückungsprozesses, insbesondere beim Applizieren mehrerer Klebepunkte gegebenenfalls auf einem Substrat, realisiert werden. Darüber hinaus kann sich auch mit zunehmender Anzahl an Stempeln die Länge des Verfahrwegs für einen Arbeitsschritt, vor allem des Verfahrwegs des Stempels relativ zum Mediumspeicher, in vorteilhafter Weise verkürzen, z.B. bei einer Rotationseinheit, bei der mehrere Stempel radial um die Drehachse angeordnet sind.

In einer vorteilhaften Ausführungsform der Erfindung ist wenigstens eine dritte Verfahreinheit zum Verfahren des zweiten Stempels zur Aufnahmeposition vorgesehen, wobei die dritte Verfahreinheit mittels der ersten Verfahreinheit verfahrbar ist. Gegebenenfalls kann pro Stempel je eine zusätzliche Verfahreinheit vorgesehen werden, wobei jede zusätzliche Verfahreinheit mittels der ersten Verfahreinheit verfahrbar ist. Mit Hilfe dieser Maßnahme bzw. Maßnahmen ist eine nahezu vollständige zeitliche Entkopplung bzw. Parallelisierung der Arbeitsschritte der einzelnen Stempel realisierbar, wodurch sich die Taktzeit des Bestückungsprozesses vor allem beim Applizieren mehrerer Klebepunkte pro Substrat deutlich reduziert. In vorteilhafter Weise kann die Anzahl der Stempel bzw. der zusätzlichen Verfahreinheiten in Abhängigkeit der Anzahl der vorhandenen Aufbringpositionen auf einem Substrat gewählt werden.

Grundsätzlich ist die erste Verfahreinheit zum Verfahren des Stempels sowohl in X-, Y- als auch Z-Richtung ausgebildet, wobei das Substrat beispielsweise in der in X/Y-Ebene ausgerichtet ist. Bei entsprechenden Verfahreinheiten ist insbesondere die Verstellung in X- bzw. Y-Richtung programmierbar und relativ präzise steuerbar. Das Verfahren des Stempels in die sogenannte Z-Richtung, d.h. quer zur Substratebene, wird im Allgemeinen vergleichsweise einfach mittels pneumatischer oder ähnlicher Antriebe realisiert.

Das Verfahren des Stempels mit Hilfe der zweiten, dritten bzw. zusätzlichen Verfahreinheit wird vorzugsweise mittels relativ einfacher pneumatischer oder ähnlicher Verstellantriebe für die X-, Y- und/oder Z-Richtung gewährleistet. Hierbei kann der Verstellantrieb gegebenenfalls lediglich zwei Arbeitspositionen ansteuern, d.h. er kann beispielsweise einen Antriebszylinder lediglich vollständig einfahren oder ausfahren. Eine vergleichsweise unpräzise Verstellung des Stempels ist zum Aufnehmen des Mediums im Allgemeinen ausreichend und besonders kostengünstig zu realisieren, wobei der Stempel im Allgemeinen in Z-Richtung nachgiebig gelagert bzw. überfedert ist.

Darüber hinaus kann in vorteilhafter Weise die Verstellung der zweiten, dritten bzw. zusätzlichen Verfahreinheit quer zur Substratebene, z.B. in Z-Richtung, mittels dem entsprechenden, bereits vorhandenen Antrieb bzw. Verstellmechanismus der ersten Verfahreinheit realisiert werden. Hierdurch verringert sich der konstruktive und finanzielle Aufwand zur Verwirklichung der zweiten bzw. zusätzlichen Verfahreinheit zusätzlich.

In einer vorteilhaften Variante der Erfindung ist wenigstens ein zweiter Mediumspeicher zur Bevorratung des Mediums vorgesehen, wobei der zweite Mediumspeicher um ein Vielfaches größer als der erste Mediumspeicher ausgebildet ist. Vorzugsweise ist eine Zufuhrvorrichtung zum Zuführen des Mediums des zweiten Mediumspeicher zum ersten Mediumspeicher vorgesehen und/oder eine Dosiervorrichtung zum Dosieren der im ersten Mediumspeicher bevorrateten Menge. Hiermit wird ermöglicht, dass eine vergleichsweise große Mediummenge zum Aufbringen gegebenenfalls auf zahlreiche Aufbringpositionen bzw. Substraten der Vorrichtung gemäß der Erfindung zur Verfügung steht und zudem eine vorgegebene, nahezu genau definierte Menge des Mediums auf das Substrat an jeder Aufbringposition aufgebracht werden kann.

Vorzugsweise umfasst die Dosiervorrichtung wenigstens ein Abstreiferelement. Diese Maßnahme gewährleistet in besonders einfacher Weise eine nahezu exakte Dosierung der im ersten Mediumspeicher gespeicherten Mediummenge, in die der Stempel eintaucht.

In einer vorteilhaften Ausführungsform der Erfindung umfasst die zweite, dritte bzw. zusätzliche Verfahrenseinheit die Zufuhrvorrichtung und/oder die Dosiervorrichtung. Beispielsweise kann die Zufuhr- bzw. Dosiervorrichtung als in X- bzw. Y-Richtung verfahrbare Komponente der zweiten, dritten bzw. zusätzlichen Verfahreinheit zum Bewegen des Stempels relativ zum ersten Mediumspeicher ausgebildet werden. Gegebenenfalls wird das Verstellen der Zufuhr- bzw. Dosiervorrichtung mittels einer relativ einfachen Verstellmechanik mit pneumatischen oder ähnlichem Antrieb realisiert. Dies führt unter anderem zu einer Reduzierung der konstruktiven und wirtschaftlichen Kosten.

Beispielsweise wird eine sogenannte Rakelstation verwendet, die im Allgemeinen sowohl die beiden Mediumsspeicher, das Abstreiferelement sowie eine vorteilhaft eindimensional verfahrbare Zufuhrvorrichtung umfasst, wodurch die Relativbewegung des Stempels zur Aufnahmeposition wenigstens teilweise in besonders einfacher Weise erfolgen kann.

Vorteilhafterweise umfasst die Baueinheit zusätzlich wenigstens die Zufuhrvorrichtung, die Dosiervorrichtung und den zweiten Mediumspeicher. Mit Hilfe dieser Maßnahme wird eine besonders kompakte Baueinheit realisierbar, wobei diese als Stempelkopf vorzugsweise an der ersten Verfahreinheit zum Verfahren angeordnet ist. In bevorzugter Weise umfasst der Stempelkopf gegebenenfalls mehrere Stempel und zumindest, eine Rakelstation einschließlich Klebstoff- bzw. Mediumreservoir sowie ein oder mehrere Abstreifer.

Vorzugsweise ist wenigstens eine Lagemesseinheit zur optischen Ermittlung einer Ist-Lage der Aufbringposition auf dem Substrat in Abhängigkeit einer Ist-Lage mindestens eines der Stempel vorgesehen. Hiermit ist eine hochpräzise Aufbringung des Mediums an einer vorgegebenen Aufbringposition auf dem Substrat realisierbar.

Beispielsweise wird die ermittelte Ist-Lage des Stempels bei gegebenenfalls zu großer Abweichung zur Ist-Lage der Aufbringposition mit Hilfe der ersten und/oder zweiten bzw. zusätzlichen Verfahreinheit nachjustiert. Möglicherweise wird der Justagevorgang mehrfach wiederholt, bis eine vorgegebene maximal tolerierbare Abweichung der Ist-Lage der Aufbringposition zur Ist-Lage des Stempels unterschritten wird. Hiernach wird der Stempel lediglich quer, insbesondere nahezu senkrecht, zum Substrat verstellt, wodurch das Medium bzw. der zähflüssige Klebstoff aufgebracht wird.

Vor allem bei Verwendung mehrerer Stempel kann eine spezielle Strahllenkungsvorrichtung zur Lenkung des optischen Strahls der Lagemesseinheit auf den jeweils zu vermessenden Stempel bzw. die jeweilige Aufbringposition verwendet werden. Hierdurch wird gewährleistet, dass in vorteilhafter Weise lediglich eine Lagemesseinheit zur Ermittlung der jeweiligen Stempel-Ist-Lage bei Verwendung mehrerer Stempel ausreicht. Hierdurch wird der konstruktive sowie finanzielle Aufwand einer Vorrichtung gemäß der Erfindung reduziert.

### Ausführungsbeispiel

Ein Ausführungsbeispiel ist in der Zeichnung dargestellt und wird anhand der Figuren nachfolgend näher erläutert.

Im Einzelnen zeigt:
- Figur 1: eine perspektivische Schemadarstellung eines ersten Stempelmoduls,
- Figur 2: eine perspektivische Schemadarstellung eines zweiten Stempelmoduls und
- Figur 3: eine perspektivische Schemadarstellung eines dritten Stempelmoduls.

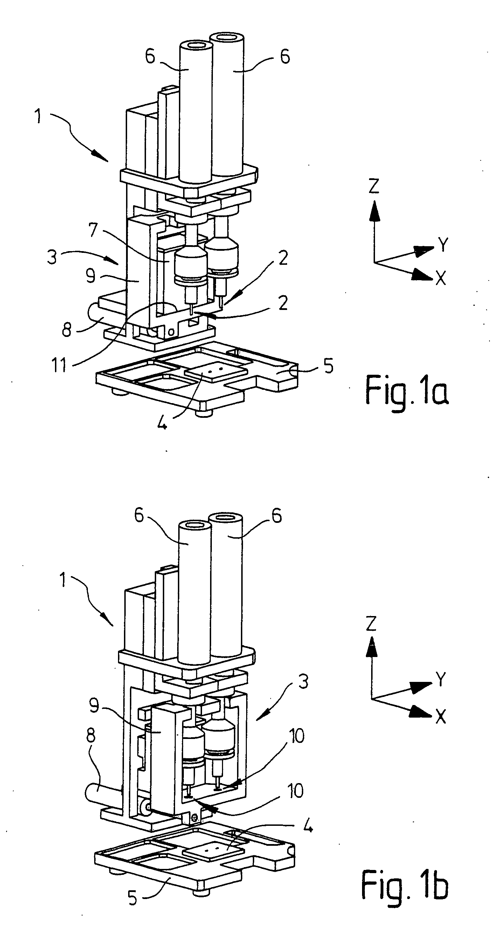

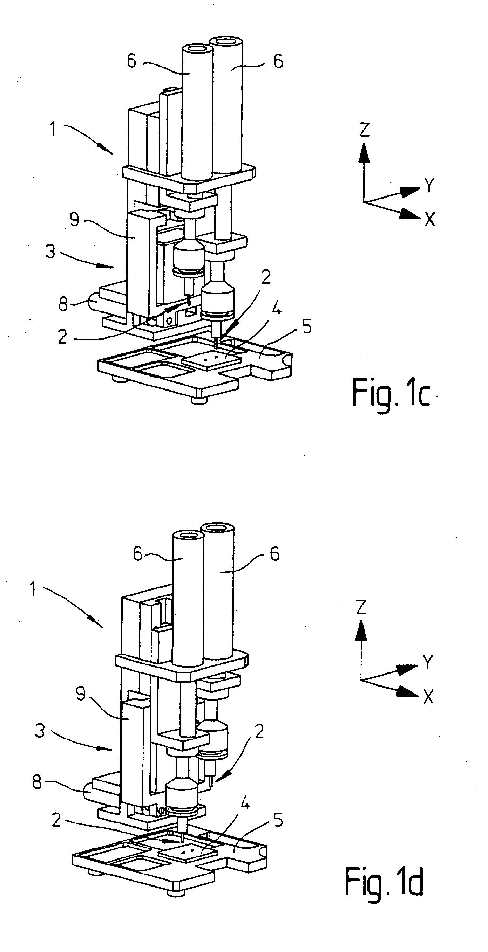

Figur 1 zeigt schematisch ein Stempelmodul 1, das beispielhaft zwei Stempel 2 sowie eine Rakelstation 3 umfasst. Grundsätzlich bezeichnen gleiche Bezugszeichen in den Figuren gleiche oder vergleichbare Elemente.

Das Stempelmodul 1 ist in nicht näher dargestellter Weise an einer zumindest zweidimensional verfahrbaren ersten Verfahreinheit angeordnet, mittels derer die Stempel 2 innerhalb eines sogenannten Die-Bonders bzw. Chipmontageautomaten verfahren werden können, wie beispielsweise zu/weg von einer Ruhe- und/oder Reinigungsposition und zu/weg von einer Aufbringposition auf einem Substrat 4. Das Substrat 4 ist auf einem Substrathalter 5 angeordnet bzw. fixiert.

Die Stempel 2 sind mittels zweier Z-Antriebe 6 unabhängig voneinander in eine Z-Richtung verfahrbar. Der Z-Antrieb 6 kann gemäß der Erfindung als Z-Antrieb 6 der nicht näher dargestellten ersten Verfahreinheit und/oder als Z-Antrieb 6 einer zweiten, dritten bzw. zusätzlichen Verfahreinheit zum Verfahren in Z-Richtung ausgebildet werden. Der Z-Antrieb 6 kann beispielsweise als elektrischer, pneumatischer oder ähnlich relativ einfach zu realisierender Antrieb 6 verwirklicht werden.

Die Rakelstation 3 umfasst insbesondere einen vergleichsweise großen Medienspeicher bzw. Vorratstank 7, in dem ein Klebstoff oder dergleichen bevorratet ist, sowie eine Kavitätenplatte 9 mit einer Kavität 10, in die der Klebstoff ausgestrichen wird.

Zur Aufnahme des Klebstoffs wird mittels einem pneumatisch oder vergleichbaren X-Antrieb 8 ein Dosierelement 9 in eine X-Richtung verfahren. Das Dosierelement 9 umfasst vorzugsweise je Stempel 2 gemäß Figur 1b eine Ausnehmung 10 bzw. die sogenannte Kavität 10, die als erster Mediumspeicher gemäß der Erfindung ausgebildet ist. Die Ausnehmung 10 wird gemäß Figur 1a aus dem in dieser Position darüber angeordneten Vorratstank 7 befüllt und mittels einer Abstreifkante 11 wird eine definierte Menge des Klebstoffs in der Ausnehmung 10 beim Verfahren in X-Richtung des Dosierelementes 9 gemäß Figur 1b zudosiert.

Mit Hilfe der Z-Antriebe 6 kann jeder Stempel 2 in die jeweilige Ausnehmung 10 eintauchen, die mit Klebstoff befüllt ist. In nicht näher dargestellter Weise taucht der Stempel 10 bis zum Grund bzw. Boden der Ausnehmung 10 ein. Vorzugsweise umfasst der Stempel 2 eine Federung bzw. Dämpfung, so dass gewährleistet ist, dass der Stempel 2 einerseits bei jedem Eintauchen bis zum Grund und somit immer bis zu einer vorgegebenen, gleichbleibenden Tiefe in den Klebstoff eintaucht. Andererseits wird der Stempel 2 hierdurch nicht unzulässig stark auf den Grund gedrückt, so dass dieser gegebenenfalls beschädigt werden würde.

Die Federung bzw. Dämpfung des Stempels 2 ist insbesondere deshalb von besonderer Wichtigkeit, da die Stempel 2 im Allgemeinen vergleichsweise dünn ausgebildet sind. Beispielsweise weisen die Stempel 2 einen Durchmesser von lediglich circa 30 bis 50 µm auf, so dass diese entsprechend empfindlich auf Krafteinwirkung sind.

Durch die vorgegebene Klebstoffmenge in der Ausnehmung 10 und die jeweils gleich bleibende Eindringtiefe des Stempels 2 wird bei jedem Eintauch- bzw. Klebstoffaufnahmevorgang die jeweils gleiche Klebstoffmenge aufgenommen. Dies ist für Anwendungen bei der Chipmontage von entscheidender Bedeutung.

In einem nachfolgenden Verfahrensschritt gemäß Figur 1c fährt beispielsweise einer der Stempel 2 mittels der nicht näher dargestellten ersten Verfahreinheit und/oder dem Z-Antrieb 6 zur Aufbringposition auf das Substrat 4. Anschließend kann das Stempelmodul 1 gegebenenfalls etwas verfahren werden, so dass der zweite Stempel 2 auf eine zweite Aufbringposition auf dem Substrat 4 aufsetzen und in definierter Weise Klebstoff gemäß Figur 1d aufbringen kann.

Anschließend kann mit der Arbeitsposition gemäß Figur 1a der Bestückungsprozess gegebenenfalls eines anderen Substrates 4 von neuem begonnen werden. Die zu bestückenden Substrate 4 können unter anderem in nicht näher dargestellter Weise mittels einem Transportband oder einer Magazineinheit zum Die-Bonder oder dergleichen gefördert werden.

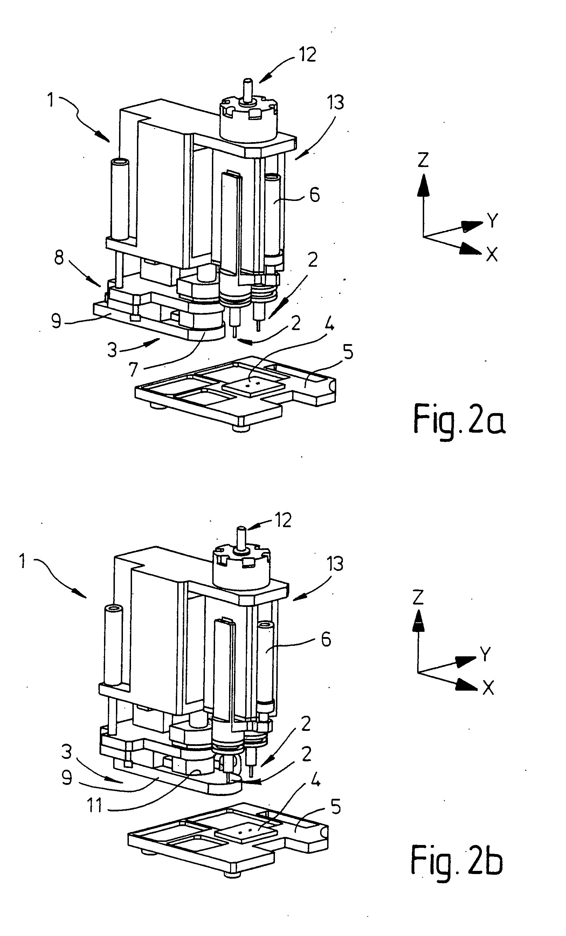

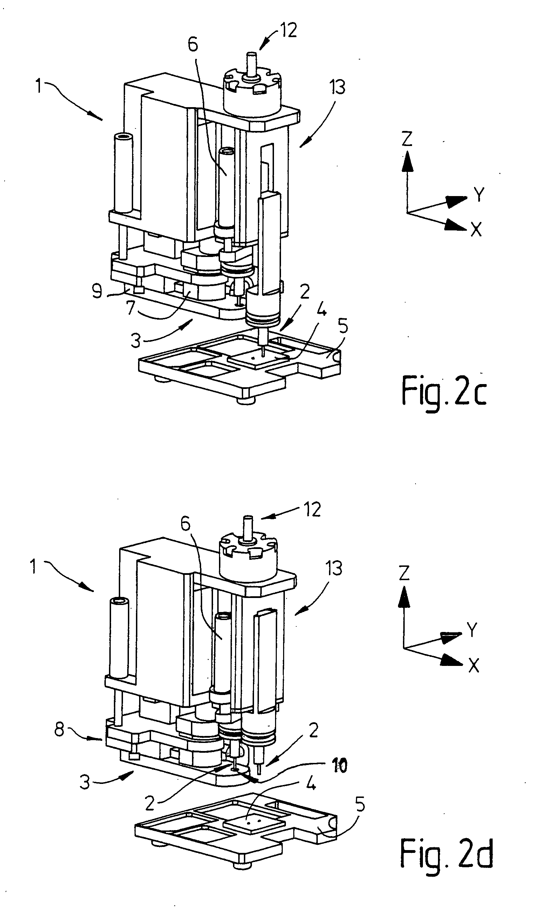

In Figur 2 ist schematisch ein weiteres Stempelmodul 1 mit einer an einer Drehachse 12 drehbar gelagerten Stempeleinheit 13 dargestellt. Die Stempeleinheit 13 umfasst hierbei zwei Stempel 2, die mittels Z-Antriebe 6 jeweils unabhängig voneinander in Z-Richtung verfahrbar sind.

Beim Stempelmodul 1 gemäß Figur 2 kann jeder Stempel 2 mittels dem Dosierelement 9 und dem X-Antrieb 8 der Rakelstation 3 bzw. dem Z-Antrieb 6 zur Aufnahme des Klebstoffs gemäß Figur 2b bzw. 2d relativ zur Ausnehmung 10 bewegt werden.

In Figur 2d wird deutlich, dass mittels dem Stempelmodul 1 gemäß Figur 2 nahezu zeitgleich jeweils ein Stempel 2 in die Ausnehmung bzw. Kavität 10 eintauchen und Klebstoff aufnehmen und der zweite Stempel 2 Klebstoff auf dem Substrat 4 aufbringen kann. Gegebenenfalls kann Klebstoff auch gemäß Figur 2b aufgenommen werden, ohne das gleichzeitig der zweite Stempel 2 Klebstoff auf dem Substrat 4 aufbringt.

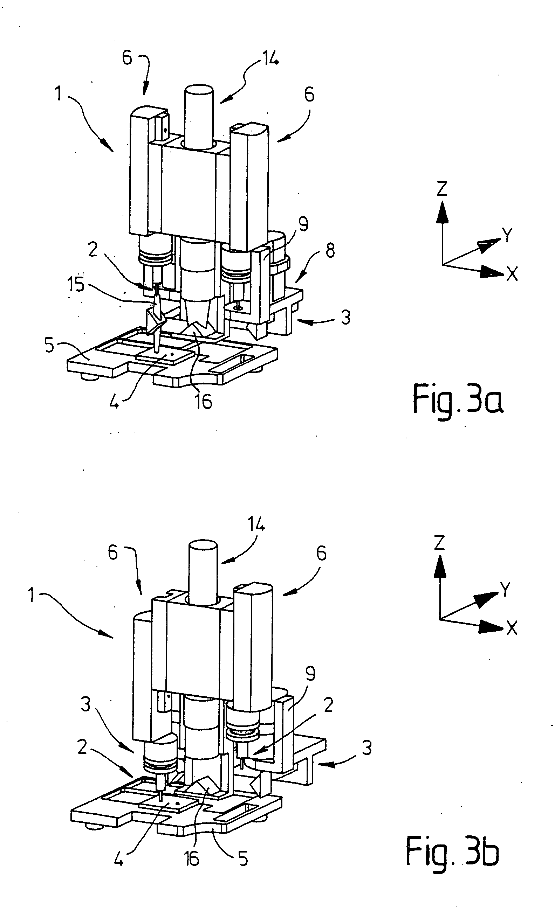

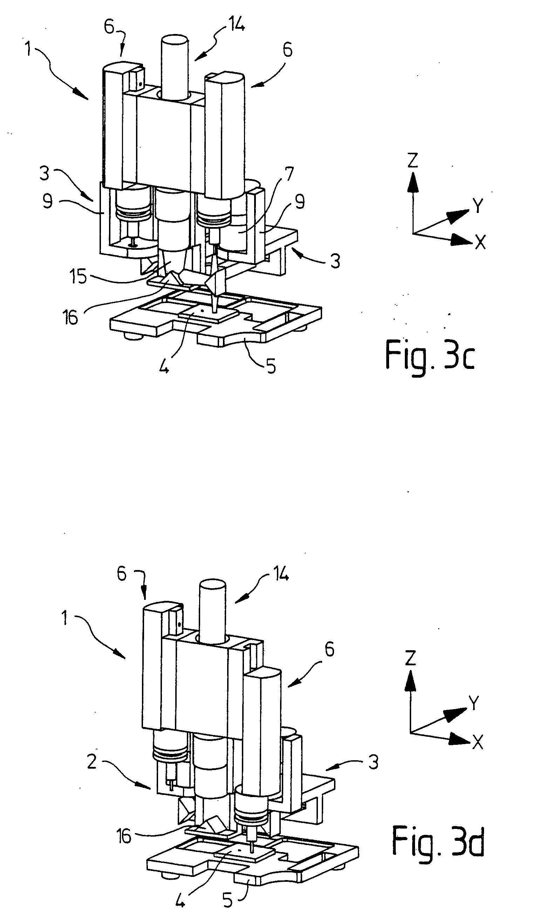

In Figur 3 ist schematisch ein drittes Stempelmodul 1 mit einer optischen Lagemesseinheit 14 dargestellt. Diese ermöglicht eine nahezu gleichzeitige Aufnahme der Ist-Lage des Stempels 2 und der Ist-Lage der Aufbringposition auf dem Substrat 4 gemäß Figur 3a bzw. Figur 3c. Bei diesen Figuren ist jeweils ein Strahlengang 15 zur besseren Veranschaulichung schematisch dargestellt.

Die Lagemesseinheit 14 umfasst ein Umlenkelement 16, mit Hilfe dessen der jeweils interessierende Stempel 2 vermessen werden kann. Beispielsweise ist das Umlenkelement 16 mittels eines nicht näher dargestellten, vergleichsweise einfach zu realisierenden Antriebes insbesondere längs der X-Richtung verstellbar ausgebildet.

Beispielsweise wird gemäß Figur 3a ein Stempel 2 sowie die Aufbringposition auf dem Substrat 4 vermessen und nahezu gleichzeitig mittels der Rakelstation 3 Klebstoff vom zweiten Stempel 2 aufgenommen.

Anschließend bringt der zuvor vermessene Stempel 2 Klebstoff auf dem Substrat 4 auf. Gegebenenfalls gleichzeitig verfährt das Dosierelement 9 mit der Ausnehmung 10 des zweiten Stempels 2 zurück (vgl. Figur 3b). Hiernach wird der zweite Stempel 2 mittels der Lagemesseineinheit 14 bzw. eine weitere Aufbringposition des Substrats 4 gemäß Figur 3c vermessen. Vorzugsweise gleichzeitig nimmt der erste Stempel 2 mittels seiner Rakelstation 3 Klebstoff auf.

Mit Hilfe des Stempelmoduls 1 gemäß Figur 3d kann eine vorgegebene exakt zu dosierende Klebstoffmenge extrem positionsgenau auf dem Substrat 4 mittels der Stempel 2 aufgebaracht werden.

Generell kann mit Hilfe der Stempelmodule 1 gemäß der Figuren 1, 2 bzw. 3 nachteilige, nicht produktive Verfahrzeiten des Stempels 2 zur Aufnahme bzw. zum Aufbringen des Klebstoffes wesentlich reduziert werden. Gegenüber dem Stand der Technik sind deutlich kürzere Taktzeiten und somit eine wesentlich höhere Produktionsrate entsprechender Chipmontageautomaten bzw. Die-Bondern realisierbar.

## Patentansprüche

1. Vorrichtung zum Aufbringen eines Mediums an einer Aufbringposition auf einem Substrat (4), insbesondere zum Pin-Transfer von Klebstoff, mit einer ersten Verfahreinheit zum Verfahren wenigstens eines Stempels (2) zur Aufbringposition, wobei der Stempel (2) zur Aufnahme des Mediums an einer Aufnahmeposition wenigstens teilweise in das in einem ersten Mediumspeicher (10) bevorratete Medium eintaucht, **dadurch gekennzeichnet, dass** wenigstens eine zweite Verfahreinheit (6, 8, 13) zum Verfahren des Stempels (2) zur Aufnahmeposition vorgesehen ist, wobei die zweite Verfahreinheit (6, 8, 13) mittels der ersten Verfahreinheit verfahrbar ist.

2. Vorrichtung nach Anspruch 1, **dadurch gekennzeichnet, dass** wenigstens die zweite Verfahreinheit (6, 8, 13), der Stempel (2) und der erste Mediumspeicher (10) als eine Baueinheit (1) ausgebildet sind.

3. Vorrichtung nach einem der vorgenannten Ansprüche, **dadurch gekennzeichnet, dass** die zweite Verfahreinheit (6, 8, 13) wenigstens eine drehbar gelagerte Rotationseinheit (13) zum radialen Verfahren des Stempels (2) umfasst.

4. Vorrichtung nach einem der vorgenannten Ansprüche, **dadurch gekennzeichnet, dass** wenigstens zwei Stempel (2) vorgesehen sind.

5. Vorrichtung nach einem der vorgenannten Ansprüche, **dadurch gekennzeichnet, dass** wenigstens eine dritte Verfahreinheit (6, 8, 13) zum Verfahren des zweiten Stempels (2) zur Aufnahmeposition vorgesehen ist, wobei die dritte Verfahreinheit (6, 8, 13) mittels der ersten Verfahreinheit verfahrbar ist.

6. Vorrichtung nach einem der vorgenannten Ansprüche, **dadurch gekennzeichnet, dass** wenigstens ein zweiter Mediumspeicher (7) zur Bevorratung des Mediums vorgesehen ist, wobei der zweite Mediumspeicher (7) um ein Vielfaches größer als der erste Mediumspeicher (10) ausgebildet ist.

7. Vorrichtung nach einem der vorgenannten Ansprüche, **dadurch gekennzeichnet, dass** eine Zufuhrvorrichtung (3) zum Zuführen des Mediums vom zweiten Mediumspeicher (7) zum ersten Mediumspeicher (10) vorgesehen ist.

8. Vorrichtung nach einem der vorgenannten Ansprüche, **dadurch gekennzeichnet, dass** eine Dosiervorrichtung (3) zum Dosieren der im ersten Mediumspeicher (10) bevorrateten Menge vorgesehen ist.

9. Vorrichtung nach einem der vorgenannten Ansprüche, **dadurch gekennzeichnet, dass** die Dosiervorrichtung (3) wenigstens ein Abstreiferelement (11) umfasst.

10. Vorrichtung nach einem der vorgenannten Ansprüche, **dadurch gekennzeichnet, dass** die zweite und/oder dritte Verfahreinheit (6, 8, 13) die Zufuhrvorrichtung (3) und/oder die Dosiervorrichtung (3) umfasst.

11. Vorrichtung nach einem der vorgenannten Ansprüche, **dadurch gekennzeichnet, dass** die Baueinheit (1) wenigstens die Zufuhrvorrichtung (3), die Dosiervorrichtung (3) und den zweiten Mediumspeicher (7) umfasst.

12. Vorrichtung nach einem der vorgenannten Ansprüche, **dadurch gekennzeichnet, dass** wenigstens eine Lagemesseinheit (14) zur optischen Ermittlung einer Ist-Lage der Aufbringposition auf dem Substrat (4) in Abhängigkeit einer Ist-Lage mindestens eines der Stempel (2) vorgesehen ist.
